# EUROPÄISCHE PATENTANMELDUNG

(11) **EP 1 566 471 A2**
(43) Veröffentlichungstag der Anmeldung: **24.08.2005**
(21) Anmeldenummer: 05003900.7
(22) Anmeldetag: 23.02.2005
(51) Int. Cl.: C30B 33/00, C30B 29/12, G02B 5/30

(54) **Herstellung von spannungsarmen, grossvolumigen Kristallen mit geringer Spannungsdoppelbrechung und homogener Brechzahl, sowie deren Verwendung**

(30) Priorität: 23.02.2004 DE 102004008753
(71) Anmelder: Schott AG, 55122 Mainz (DE)
(72) Erfinder: Parthier, Lutz, Dr., 14532 Kleinmachnow (DE); Stäblein, Jörg, 07743 Jena (DE); Wehrhan, Gunther, Dr., 07749 Jena (DE); Kusch, Dr. Christian, 81667 München (DE)
(74) Vertreter: Fuchs Mehler Weiss & Fritzsche

(57) **Zusammenfassung**

Es wird ein Verfahren zur Herstellung von spannungsarmen, großvolumigen Kristallen beschrieben, die eine geringe Doppelbrechung und eine homogene Brechzahl aufweisen. Das Verfahren umfasst Züchten eines Kristalles aus einer Schmelze, Abkühlen des so erhaltenen Kristalles, sowie Tempern und Bearbeiten auf eine gewünschte Dimension, und zeichnet sich dadurch aus, dass man den Kristall in einer größeren als der gewünschten Dimension tempert, und man nach dem Tempern und Abkühlen den äußeren Randbereich auf die gewünschte Dimension abträgt und dass nach dem Entfernen des Randes kein weiteres Tempern erfolgt. Mit dem Verfahren sind Kristalle erhältlich, die eine homogene Brechzahl von Δn < 1*10⁻⁶ und/oder eine Spannungsdoppelbrechung < 0,3nm/cm aufweisen und die als optisches Element zur Herstellung von Steppern, Excimer-Lasern, Computerchips, sowie integrierten Schaltungen und elektronischen Geräten, die solche Schaltungen und Chips enthalten, verwendbar sind.

## Beschreibung

Die Erfindung betrifft die Herstellung von spannungsarmen, großvolumigen Kristallen, die über ihr Volumen hinweg eine geringe Doppelbrechung und eine homogene Brechzahl aufweisen, mittels einem insbesonders gerichteten Tempern, die Verwendung derartiger Kristalle, sowie derartige Kristalle und optische Elemente selbst.

Durch die Notwendigkeit Linsen und optische Systeme auch für Wellenlängen außerhalb des für den Menschen sichtbaren Bereiches zu verwenden, finden immer häufiger Kristalle, insbesonders Einkristalle Verwendung. So werden beispielsweise bei der Herstellung von Computerchips mittels Mikrolithographie Laser zum Belichten im tiefen UV-Bereich (DUV) insbesonders bei Wellenlängen unter 250 nm, speziell 248 nm, 193 nm bzw. 157 nm eingesetzt. Als optische Elemente bzw. Linsen in Beleuchtungs- und Abbildungsoptiken bei 193 nm und vorzugsweise bei 157 nm werden große Einkristalle verwendet. Als ein bevorzugtes Material hierfür hat sich CaF₂ durchgesetzt. Zur Herstellung integrierter Schaltungen, z. B. Computerchips, ist es notwendig, dass derartige Optiken auch kleinste Strukturen fehlerfrei, d. h. scharf abbilden, um ein einwandfreies Produkt zu erhalten. Um die hierfür notwendige Abbildungsqualität zu erreichen, werden an das optische Grundmaterial, d. h. an den Kristall, sehr hohe Anforderungen gestellt. Dabei soll die Brechzahl n so homogen wie möglich sein, d. h. deren Schwankungen im Linsenrohling soll nicht mehr als 1*10⁻⁶ betragen und die Spannungsdoppelbrechung soll deutlich unter 1 nm/cm liegen.

Die Verknüpfung zwischen mechanischen Größen (wie z. B. Spannungen) und der durch sie verursachten optischen Wirkung (wie z. B. die Spannungsdoppelbrechung SDB) ist im Kristall (richtungsabhängig) über den spannungsoptischen Tensor gegeben. Das bedeutet, Spannungen gleicher Größe können in einem einkristallinen Material in Abhängigkeit von der kristallographischen Orientierung bzw. der Beobachtungsrichtung zu deutlich unterschiedlicher Spannungsdoppelbrechung und Brechzahlhomogenität führen. Aus diesem Grunde wurden bisher Bauelemente eingesetzt, bei denen die minimale Spannungsdoppelbrechung in der Anwendungsrichtung zu beobachten ist. Das ist für Calciumfluorid in der (111)-Richtung der Fall. Bisher wurde daher Material ausschließlich in der Orientierung (111) für Linsenrohlinge (bzw. (111)-nahe für Kuben) eingesetzt.

Es sind daher bereits eine Vielzahl von Verfahren zur Herstellung großvolumiger Einkristalle für den genannten Zweck bekannt. So beschreibt beispielsweise die DE-A 100 10 484 eine Vorrichtung zum Züchten von großvolumigen Einkristallen und die DE-A 100 10 485 ein Verfahren zum Tempern derartiger Kristalle zur Reduzierung der Spannungsdoppelbrechung. Dabei wird üblicherweise von Kristallen ausgegangen, die vor dem Tempern eine durchschnittliche Spannungsdoppelbrechung (RMS-Werte) von ca. 5 - 20 nm/cm aufweisen. Mit den beschriebenen Verfahren lässt sich die Spannungsdoppelbrechung an Kristallen auf bis zu 1 nm/cm verringern und die Brechzahldifferenzen derart zu reduzieren, dass innerhalb eines Kristalles die Brechzahlen um nicht mehr als Δn = 5*10⁻⁶ von einander abweichen. Dabei wird der fertig gezüchtete Kristall in einen Temperofen eingebracht und mindestens 2 Stunden lang oberhalb 1150°C im Beisein eines die Verdampfung des Kristalles verringerndes CaF₂-Pulvers erwärmt. Auch in der DD-PS-213514 wird ein Temperverfahren beschrieben, bei dem ein CaF₂-Kristall in einer PbF₂-haltigen Atmosphäre bei einer Temperatur von 1200°C erhitzt wird, wobei im Kristall eine vorliegende Spannungsdoppelbrechung von 10 - 25 nm/cm (RMS-Wert) durch eine 2 - 3- stündige Erwärmung auf 1200°C auf nur 1 nm/cm verringert wird.

In der JP-A 2001-335 398 wird ein Temperverfahren zum Abbau der Spannungsdoppelbrechung und zur Erhöhung der Homogenität des Brechungsindexes beschrieben, wobei der Kristall zuerst in einem Bereich von 1020 - 1150°C für eine vorgegebene Zeit erwärmt wird und mit einer Abkühlgeschwindigkeit von 1°C pro Stunde dann auf eine Temperatur unterhalb 700°C abgekühlt wird.

In der JP-A 10-251 096 wird daher ferner das Vorgehen beschrieben, den Kristall vor dem Tempern auf eine für das Endprodukt endmaßnahe Dimension zurecht zu schneiden und anschließend einem Temperverfahren zu unterziehen.

Ausgehend von theoretischen Betrachtungen zwischen der Dimension von Kristallkörpern wie Durchmesser und Dicke und im Material auftretenden, die Spannungsdoppelbrechung hervorrufenden Spannungen müssen Kristalle in möglichst kleinen Dimensionen getempert werden. Da die durch beim Erwärmen bzw. Abkühlen im Kristall zwischen verschiedenen Orten zwangsläufig auftretenden Temperaturunterschiede ΔT hervorgerufenen Spannungen proportional zum Quadrat der Dicke bzw. Höhe des Kristalls und proportional dem Quadrat des Durchmessers einer Scheibe sind, d. h. ΔT~d² und ΔT~h², ist bislang davon ausgegangen worden, die Kristalle mit möglichst geringstem Volumen zu Tempern. Dabei bewirkt eine Vergrößerung des Durchmessers bzw. der Höhe oder Dicke des Kristallkörpers beim Tempern unter sonst identischen Bedingungen eine Zunahme der Spannungsdoppelbrechung.

Beim Tempern erfolgt nämlich ein nahezu vollständiger Abbau von im Kristall vorhandenen Spannungen über eine plastische Verformung im Kristallgitter durch Aktivierung von Gleitprozessen entlang der durch die jeweilige Struktur des Kristallgitters vorgegebenen Gleitsysteme sowie über atomare Diffusionsmechanismen (Kletterprozesse). Daher ist es, um einen über das gesamte Kristallvolumen hindurch defektarmen Kristall zu erreichen, notwendig, dass eine möglichst hohe Temper- oder Annealingtemperatur eingestellt wird; wobei generell gilt, je höher die Temperatur desto geringer ist die verbleibende Restspannung, wobei dem Kristall ausreichend Zeit gegeben werden muss, damit die gewünschten Gleit- und Diffusionsprozosse ablaufen können. Hierbei soll möglichst während des gesamten Temperprozesses, bestehend aus Aufheizphase, Haltezeit bei Maximaltemperatur und Abkühlphase, eine extrem homogene Temperaturverteilung im gesamten Kristallvolumen gewährleistet sein.

Die räumliche Temperaturverteilung im gesamten Kristallvolumen ergibt sich aus einer Überlagerung von statischen Temperaturgradienten (anlagenbedingte Temperaturverteilung) mit einem dynamischen Temperaturgradienten, welche infolge von Aufheiz- bzw. Abkühlvorgängen im Kristall entstehen. Erstere dominieren die Haltezeit, letztere kommen vor allem in der Aufheiz- und Abkühlphase zum tragen. Dabei wurde bislang davon ausgegangen, dass die Orientierung des Kristalls im Temperaturfeld irrelevant für das Temperergebnis ist, da sich das Volumen bei Maximaltemperatur (Haltetemperatur) lange in einem wesentlich homogeneren, statischen Temperaturfeld befindet, als das in der Aufheizphase oder der Abkühlphase der Fall ist.

Um das durch das Tempern erzeugte mehr oder weniger spannungsfreie Kristallgefüge zu erhalten, wird dann derart abgekühlt, dass möglichst kein Temperaturgradient im Kristall erzeugt wird, der neue Spannungen hervorruft. Es hat sich gezeigt, dass Spannungen im Material zuerst zu elastischer und später bei Überschreiten eines kritischen Wertes zu plastischer Deformation des Materials führen. Die Erfindung hat daher zum Ziel, Kristalle insbesonders für die Verwendung als optische Elemente bereitzustellen, die eine stark verbesserte Spannungsdoppelbrechung sowie eine erhöhte Homogenität des Brechungsindex über das gesamte Kristallvolumen hinweg aufweisen.

Dieses Ziel wird durch das in den Ansprüchen definierte Verfahren erreicht.

Erfindungsgemäß wurde nämlich nicht nur gefunden, dass die stärkste Spannungsdoppelbrechung am Rand des Kristalles vorliegt, sondern dass die im Inneren des Kristalles auftretende Spannungsdoppelbrechung und die spannungsbedingten Brechzahlunterschiede sich durch Abtragen bzw. Entfernen des Kristallrandes nach dem Tempern mehr oder weniger vollständig entfernen lassen. Wie erfindungsgemäß ebenfalls gefunden wurde, beruhen diese offenbar auf elastischen Restspannungen, die durch Entfernung des spannungsausübenden Randes im Wesentlichen vollständig relaxieren können.

Erfindungsgemäß wird daher derart vorgegangen, dass aus einem Rohkristall ein orientiertes Blank herausgeschnitten wird, welches ein im Vergleich zum Stand der Technik wesentlich größeres Aufmaß besitzt. Dieses mit einem Aufmaß behaftete Blank wird nun wie üblich in einem dafür geeigneten Ofen bzw. einer Anlage getempert. Das Aufmaß wird erst nach dem Tempern abgetragen. Vorzugsweise wird das Übermaß vom Kristallmittelpunkt aus bezüglich seiner Höhe und/oder seines Durchmessers entlang des Umfangs bzw. äußeren Randes zirkumferential entfernt. In einer bevorzugten Ausführungsform beträgt das Aufmaß bzw. die Vergrößerung mindestens 5%, vorzugsweise mindestens 10% des Endmaßes bzw. der endmaßnahen Dimension, wobei ein Aufmaß bzw. Übermaß von +15%, insbesondere +20%, bevorzugt ist. Als besonders bevorzugt haben sich Aufmaße von +25 bzw. +30% erwiesen. Dabei beziehen sich die Aufmaße vorzugsweise auf den Durchmesser bzw. die Höhe des Kristalls. Soll beispielsweise das Endmaß bzw. die endmaßnahe Dimension des Kristalls 20 cm aufweisen, so wird der Kristall bei einem 20%-igen Aufmaß mit einem Durchmesser von mindestens 24 cm getempert. Ein späteres Tempern nach Entfernung des Randes, der die innere elastische Restspannung im Kristall verursacht, sollte nicht mehr stattfinden.

Es hat sich überraschenderweise gezeigt, dass sich mittels diesem Verfahren orientierte Blanks erhalten lassen, die bezüglich des RMS-Wertes der Brechzahlhomogenität besser als 0,025 x 10⁻⁶, insbesonders besser als 0,015 x 10⁻⁶ sind. Diese Homogenitätswerte werden in den Orientierungen 111, 110 und/oder 100 erreicht. Bezüglich der Spannungsdoppelbrechung lassen sich Werte erhalten, wie sie in folgende Tabelle eingetragen sind:

**Tabelle 1**

| | <111>-Orientierung | | <100> bzw. <110>-Orientierung | |
|---|---|---|---|---|
| | bevorzugt | besonders bevorzugt | bevorzugt | besonders bevorzugt |
| SDB - PV-Wert in nm/cm | 0,5 | 0,2 | 2,5 | 1 |
| SDB - RMS-Wert in nm/cm | 0,15 | 0,08 | 1 | 0,35 |

Das erfindungsgemäße Verfahren eignet sich zur Herstellung von Kristallen aller Formen und aller Orientierungen. So ist es beispielsweise ohne weiteres möglich, auch Kristalle anstatt in (111)-Richtung in (100)-, oder (110)-Orientierung annähernd spannungsfrei zu erhalten, was mit den bisherigen Verfahren des Standes der Technik nicht möglich war.

Die erfindungsgemäße Herstellung von Kristallen kann nach den an sich bekannten Verfahren nach der sog. Gradientenverfestigungsmethode (gradient solification method (GSM)) durchgeführt werden. Weitere übliche bekannte, im industriellen Maßstab durchführbare Verfahren sind beispielsweise das Bridgman-Stockbarger-Verfahren, das Vertical-Gradient-Freeze-Verfahren, das Nacken-Kyropoulos-Verfahren und das Czochralski-Verfahren. Dabei wird jeweils polykristallines Material in einem Tiegel aufgeschmolzen und anschließend die Schmelze langsam, vorzugsweise mittels eines Impfkristalles, in gerichteter Weise erstarren gelassen. Anschließend wird bei all diesen Verfahren langsam abgekühlt, um Kristalle mit bereits geringen thermischen Verspannungen zu erhalten. Alle derartig erhaltenen Kristalle sind für das erfindungsgemäße Verfahren geeignet.

Das Tempern selbst wird vorzugsweise bei einer Temperatur oberhalb 1000°C durchgeführt. Dabei wird der Kristall vorzugsweise solange erwärmt bis über sein gesamtes Volumen hinweg eine einheitliche Temperatur herrscht, d. h., dass kein Temperaturgradient mehr vorliegt und die Relaxationsvorgänge im Kristall abgelaufen sind.

Erfindungsgemäß ist es auch bevorzugt, dass beim Tempern und/oder beim Gettern mit einem Scavenger im Kristall eine möglichst homogene Temperatur herrscht, die dazu üblicherweise an keiner Stelle im Temperraum um mehr als 5°C, insbesondere mehr als 2°C, vorzugsweise mehr als 1°C verschieden ist.

Es hat sich gezeigt, dass sich die Kristalldefekte im CaF₂ hinreichend weit reduzieren lassen, um die genannten Ziele zu erreichen, wenn der Kristall auf Temperaturen von über 1000°C erwärmt wird und bei der eingestellten Temperatur wenigstens 65 Stunden, vorzugsweise mindestens 75 Stunden gehalten wird, wobei mindestens 80 Stunden besonders bevorzugt sind. Erfindungsgemäß wurde gefunden, dass entgegen bisherigen Vorstellungen diese gegenüber bisher bekannten Prozessen deutlich verlängerte Zeit erforderlich ist, um die notwendigen Relaxationsvorgänge im Kristall ablaufen zu lassen.

Die einzustellende Temperhaltetemperatur beträgt erfindungsgemäß mindestens 1000°C, vorzugsweise mindestens 1050°C, wobei mindestens 1080°C bzw. 1100°C besonders bevorzugt sind. Ganz besonders bevorzugt ist ein Tempern oberhalb 1200°C, wobei oberhalb 1210°C besonders bevorzugt ist. Als obere Tempergrenze sollte 1415°C vorzugsweise 1370°C nicht überschritten werden. Die Obergrenzen betragen maximal 1360°C, wobei 1350°C bevorzugt ist. Zweckmäßige Obergrenzen betragen erfindungsgemäß maximal 1300°C, wobei eine maximale Temperatur von 1250°C bzw. 1200°C in den meisten Fällen ausreichend ist. Erfindungsgemäß hat es sich auch als vorteilhaft erwiesen, dass während der Haltezeit möglichst keine oder nur minimale Temperaturunterschiede im Kristall auftreten, d. h. dass die Temperatur über das gesamte Kristallvolumen hinweg möglichst gleich bzw. homogen ist.

Die extremen Anforderungen an die Spannungsfreiheit der Kristalle werden insbesonders dann erfüllt, wenn die dynamischen Temperaturgradienten während der Aufheizphase und was noch wesentlich bedeutungsvoller ist, während der Abkühlphase so reduziert werden, dass sie unwesentlich größer als die statischen Temperaturgradienten während der Haltezeit bei Maximaltemperatur sind.

Vorzugsweise lässt man den Ausheilprozess in einer Anlage ablaufen, die in dem Bereich, in dem sich das zu tempernde Material befindet, einen statischen radialen Temperaturgradienten von kleiner als 0,013 K/cm und einen axialen Temperaturgradienten von kleiner als 0,07K/cm gewährleistet.

Es hat sich als zweckmäßig erwiesen beim Tempern zuerst auf eine Temperatur von 350°C - 600°C , insbesondere 350°C - 500°C zu erwärmen, um die Restfeuchte an der Oberfläche Calciumfluorid-Kristalls sowie bei der Lagerung eingebrachtes Wasser zu entfernen. Besonders bevorzugt ist eine Erwärmung von 350°C - 400°C. Dies geschieht vorzugsweise unter Vakuum. Die Wassertrocknung beträgt üblicherweise 12 - 45 Stunden, vorzugsweise 24 Stunden.

Vorzugsweise sind erfindungsgemäß beim Aufheizen Raten von weniger als 18K/h einzustellen, vorzugsweise weniger als 12K/h, wobei Aufheizraten von weniger als 10K/h besonders bevorzugt sind. Erfindungsgemäß wurde auch gefunden, daß geringe Aufheizraten wesentlich sind, um ein gutes Temperendergebnis zu erreichen. Es hat sich nämlich gezeigt, daß auch während des Aufheizens generierte Defekte im Falle von nicht (111)-orientierten Blanks sich einerseits wesentlich störender auf das Endergebnis auswirken und andererseits wesentlich schwerer (während der Haltezeit) relaxieren.

Gemäß der vorliegenden Erfindung sind beim Abkühlen Raten einzuhalten, welche im oberen Temperaturbereich der Abkühlphase kleiner 0,5K/h, vorzugsweise kleiner 0,4 K/h, und insbesondere kleiner 0,3 K/h betragen und in einem unteren Temperaturbereich der Abkühlphase erhöht werden können.

Die Erhöhung der Abkühlraten in dem unteren Temperaturbereich ist wünschenswert und auch möglich, um die Prozesszeit und die damit verbundenen Kosten nicht unnötig zu erhöhen.

Die Erhöhung der Abkühlrate kann in einem Schritt, bevorzugt aber in mehreren Schritten erfolgen. Die Temperaturraten im unteren Temperaturbereich dürfen gemäß dieser Erfindung nicht über 3 K/h, bevorzugt nicht über 2 K/h, insbesondere nicht über 1,7 K/h erhöht werden.

Die Grenztemperatur welche den oberen von dem unteren Temperaturbereich der Abkühlphase trennt, liegt in dem Bereich zwischen 900°C und 600°C. Die Übergangstemperatur liegt dabei umso tiefer, je höher die Qualitätsanforderungen an das Produkt sind.

Die Anlage sollte vorzugsweise in ihrem Inneren ausschließlich aus hochreinem Graphit bestehen, um Kontaminationen der CaF₂-Kristalle auszuschließen, welche zu einer Minderung der Transmission führen können.

Die Anforderungen an die Reinheit bestehen ebenso an die zu tempernden Produkte. Vor Beschickung der Anlage sind daher die Teile einer sorgfältigen Reinigung zu unterziehen. Die Teile sollen sowohl fett- und staubfrei sein, sowie möglichst keine Oberflächenfeuchte ausweisen. Bevorzugt wird daher eine Reinigung der Teile mit fettlösenden organischen Lösungsmitteln mit hohem Dampfdruck. Nach erfolgter Reinigung ist jede Berührung der Teile mit bloßer Haut oder verschmutzten Gegenständen zu vermeiden.

Es hat sich auch als zweckmäßig erwiesen, das Tempern unter Schutzgas durchzuführen. Übliche Schutzgase sind Stickstoff, Helium, Argon und/oder Xenon.

Zur Entfernung des in der Anlage, an der Kristalloberfläche bzw. im Kristallgitter vorhandenen Restsauerstoffs wird vorzugsweise wenigstens ein Scavenger-Material eingesetzt. Als vorteilhaft erweisen sich Verbindungen wie ZnF₂, PbF₂, XeF₂, SnF₂, welche als Feststoffe zugesetzt werden. Es ist auch möglich, nach einer ausgeprägten Trockenphase gasförmige Scavenger einzusetzen. Hierbei sind besonders Fluorgas, Fluorgas/Inertgasmischungen, Fluorkohlenstoffgase bzw. Fluorkohlenwasserstoffgase vorteilhaft zu verwenden. Eine Kombination von fest- und gasförmigen Scavengern kann auch verwendet werden.

In einer bevorzugten Ausführungsform wird die Temperung unter Einsatz von gasförmigem Scavenger vorgenommen, beispielsweise CF₄, C₂F₆, C₃F₈ oder CHF₃, SF₆ oder NF₃ bevorzugt unter dem Einsatz von Fluorkohlenstoffgasen, welche mit Inertgas vermischt in einer Konzentration von 1-50%, insbesondere 5-30%, speziell 5-15% in die Anlage eingebracht wird. Durch den Einsatz dieses Gases gelingt es überraschenderweise die Transmission des CaF₂ zu erhöhen. Dieser Effekt wird nicht bei Einsatz von Inertgas, Vakuum oder pulverförmigen Scavengermaterial erreicht.

In einer besonders bevorzugten Ausführungsform wird das Tempern auch in einer fluorhaltigen Atmosphäre, insbesondere einem fluorhaltigen Schutzgas durchgeführt. Hierbei wird Fluorgas in einen Temperofen bzw. in ein das Tempergut enthaltendes Tempergefäß eingeleitet und/oder durch Verdampfen freigesetzt. Weitere, geeignete reaktive Fluorgase sind Tetrafluormethan sowie andere Fluorkohlenstoffe oder Fluorkohlenwasserstoffe.

Eine besonders bevorzugte fluorhaltige Atmosphäre ist eine HF-Atmosphäre. In einer weiteren bevorzugten erfindungsgemäßen Ausführungsform wird die fluorhaltige Atmosphäre zusammen mit einem Schutzgas verwendet. Zweckmäßigerweise enthält die dabei entstehende Gasmischung 0,1-20% Fluorgas, insbesondere 1-10%. Eine besonders bevorzugte Mischung ist eine Mischung aus HF und N₂.

In einer ganz besonders bevorzugten Ausführungsform wird die fluorhaltige Atmosphäre in Form von fluorfreisetzenden Festkörpern wie beispielsweise XeF₂ eingebracht. XeF₂ ist bei Raumtemperatur ein Festkörper, der sich bei einer Temperatur oberhalb 400°C zu Xe und F₂-Gas zersetzt. Zweckmäßigerweise wird es luftdicht verschlossen in einen Teflonbeutel eingesetzt.

Es hat sich als besonders zweckmäßig erwiesen, dass das Tempern in einer reduzierenden Atmosphäre durchgeführt wird. Eine reduzierende Atmosphäre wird beispielsweise durch den Zusatz von Grafitpulver erreicht, welches mit Wasser unter Ausbildung von CO/CO₂ und CH₄ reagiert, wobei CH₄ selbst eine reduzierende Wirkung aufweist. Auch das teilweise gasförmige Bleifluorid weist gegenüber Calciumoxid eine reduzierende sauerstoffentziehende Wirkung auf. Auf diese Weise können im Calciumfluoridkristall vorliegendes oder durch Wasseranlagerung entstandenes Calciumoxid zu Calciumfluorid umgewandelt werden, was sowohl der Ausscheidungsbildung als auch der Verringerung von Kleinwinkelkorngrenzen dient.

In besonderer Weise bevorzugt wird eine Ausführung wie zuvor beschrieben, bei der während des Temperprozesses ein Gasgemisch mit der zuvor angegebenen Zusammensetzung mit einem Durchfluss von wenigen Litern pro Minute durch die Anlage strömen lässt.

Bei besonderer Sorgfalt bezüglich der Reinheit und Sauerstofffreiheit aller in der Anlagen befindlichen Materialien und Oberflächen kann auf ein Scavengermaterial verzichtet werden. Dabei ist zunächst eine Trocknung im Hochvakuum auszuführen, um adsorbiertes Oberflächenwasser und Sauerstoff vollständig zu entfernen. Die Temperung kann im Vakuum, aber auch in einer Inertgasatmosphäre stattfinden.

Auch hat es sich als zweckmäßig erwiesen, im Inneren des das Tempergut enthaltenden Tempergefäßes einen Calciumfluorid-Partialdruck von 0,7-1,5 mbar, insbesondere 0,8-1 mbar aufrecht zu erhalten. Dies wird vorzugsweise durch Beigabe von CaF₂-Pulver als Temperpulver erreicht. Dabei ist das Tempergefäß, das üblicherweise in einem zweckmäßigerweise evakuierbaren Temperofen eingebaut ist, vorzugsweise derart ausgestaltet, dass es nicht gasdicht ist. Der Abtransport von Gasen aus dem Inneren des Tempergefäßes wird so nur behindert, aber nicht verhindert. Der Grad der Behinderung des Abtransportes von Gasen ist so bemessen, dass in der Trocknungsphase zwischen 350°C und 600°C, insbesondere 350°C und 500°C und besonders bevorzugt 350°C bis 400°C, das von der Oberfläche des Tempergutes bzw. des Tempergefäßes entfernte Wasser bzw. die entfernten Gase ausreichend gut in das Volumen außerhalb des Tempergefäßes entweichen können. Gleiches gilt für die Heranführung und den Abtransport von Schutzgasen bzw. gasförmigen Scavengern. In den oberen Temperaturbereichen (höher als 600°C) soll die Gestaltung des Tempergefäßes die Aufrechterhaltung des bereits genannten CaF₂-Partialdruckes und im Falle der zusätzlichen Verwendung von festen Scavengern einen je nach Scavengerart, Temperaturbereich und zugegebener Menge an Scavenger bestimmten Scavengerpartialdruck gewährleisten. Über große Temperaturbereiche herrschen dadurch für bestimmte Stoffe quasistationäre Zustände, solange noch ausreichend Temperpulver, Scavengerpulver und/oder Schutz- bzw. Fluorgas vorhanden ist.

Vorzugsweise wird beim Tempern ein feinteiliges Calciumfluoridpulver mit einer mittleren Korngröße von 100 nm - 1 mm verwendet. Übliche mittlere Korngrößen betragen 1 - 200 µm, vorzugsweise 5 - 100 µm und insbesondere von 10 - 50 µm. Die Oberfläche des feinteiligen Calciumfluoridpulvers sollte mindestens das 10fache, vorzugsweise mindestens das 100fache der Oberfläche des zu tempernden Gutes betragen. In besonders bevorzugten Ausführungsformen weist das Pulver mindestens das 1.000fache, in manchen Fällen mindestens das 5.000fache oder sogar 10.000fache der Oberfläche des Tempergutes auf.

Besonders bevorzugt ist es, die zu tempernden Kristalle und gefertigten Optiken direkt in das Temperpulver einzubetten, so dass dies einen innigen direkten Kontakt zum Pulver hat. Es hat sich nämlich gezeigt, dass sich hierbei besonders gut störende Verunreinigungen entfernen lassen.

Zur Entfernung von vorhandenem Sauerstoff im Kristallgitter enthält das Calciumfluoridpulver vorzugsweise zusätzlich mindestens einen Scavenger. Bevorzugte Scavenger sind PbF₂, ZnF₂, SnF₂, Grafit sowie andere niedrig schmelzende Fluoride und/oder Fluorverbindungen, die mit Sauerstoff flüchtige Verbindungen eingehen. Ein weiterer bevorzugter Scavenger ist XeF₂, welches bei Raumtemperatur fest ist, sich jedoch beim Erwärmen in Xe-Gas und F₂-Gas zersetzt und so als Niedrigtemperatur-Scavenger dient. Die bevorzugten Korngrößen der Scavenger entsprechen denen des CaF₂-Pulvers, sie können jedoch von diesen verschieden sein.

In einer besonders bevorzugten Ausführungsform enthält das beim Tempern zugesetzte Pulver feinteiligen Kohlenstoff, insbesondere Grafit.

Vorzugsweise folgt die Wärmezufuhr seitlich auf den zu tempernden Kristall und zwar unabhängig von der Länge des Diffusionsweges und unabhängig vom Verhältnis Durchmesser zur Höhe. Prinzipiell kann die Wärmezufuhr allerdings auch über die untere und obere Fläche des Kristallkörpers erfolgen. In einer weiteren bevorzugten Ausführungsform sind die Oberfläche, über welche die Wärme zugeführt wird und/oder die Oberfläche, über die keine Wärme zugeführt wird abgedeckt. Bevorzugte Abdeckungen sind Graphitmatten oder Graphitplatten. Graphitplatten tragen zur Verringerung des Temperaturgradienten im Tempergut bei, indem eine gleichmäßige Wärmezu- und -abfuhr in bzw. aus dem Kristall befördert wird. Die Graphitabdeckungen haben eine gute Wärmeleitfähigkeit.

Erfindungsgemäß umfasst das Kristallmaterial sämtliche Alkali- und Erdalkalifluoride, wie CaF₂, BaF₂, SrF₂, MgF₂ sowie NaF, LiF und KF. Auch Kristalle von gemischten Fluoriden sind erfindungsgemäß geeignet.

Die Erfindung betrifft nicht nur das Verfahren, sondern auch die mit dem Verfahren erhaltenen besonders spannungsarmen und bezüglich ihrer Brechzahl sehr homogenen Kristalle. Die erfindungsgemäßen Kristalle weisen die zuvor beschriebenen Eigenschaften auf.

Die Erfindung betrifft auch die Verwendung der so erhaltenen Kristalle für optische Zwecke, insbesonders als Rohling bzw. Halbzeuge für optische Elemente. Eine bevorzugte Anwendung der so erhaltenen Kristalle betrifft die Mikrolithographie, üblicherweise die Mikrolithographie < 250 nm, insbesonders bei 248 nm bzw. bei 193 nm und vorzugsweise bei 157 nm.

Die erfindungsgemäß erhältlichen optischen Elemente sind insbesonders Prismen und Linsen, die in optischen Anordnungen, insbesonders Objektiven verwendet werden. Werden diese in der Mikrolitho- und Photographie eingesetzt, dann sind damit Stepper, Excimer-Laser, Wafer, Computerchips herstellbar, sowie integrierte Schaltungen und elektronische Geräte, die solche Schaltungen und Chips enthalten.

Die Erfindung soll anhand des folgenden Beispiels näher erläutert werden.

### Beispiel

Es wurde ein Kalziumfluoridkristall wie folgt hergestellt: Hochreines, synthetisch hergestelltes CaF₂-Pulver wird mit einem Scavenger (z.B. ZnF₂ oder PbF₂) vermischt. In Portionen von 30-60kg wird das Gemisch in Graphittiegel gegeben, die einzeln oder gleichzeitig in einem Ofen unter Vakuum einem Kristallzuchtprozess unterworfen werden, der typischerweise aus einer Trocknungsphase, die der Entfernung von Wasser und Gasen von der Oberfläche und aus den Poren des Pulvers dient, einer Scavengerphase, in der noch verbliebener Sauerstoff entfernt wird, einer Homogenisierungsphase, in deren Verlauf flüchtige Verunreinigungen abdampfen können und in deren Ergebnis das nun geschmolzen vorliegende CaF₂ völlig homogen vorliegt und einer Kristallisationsphase, in der der Kristall recht schnell gerichtet oder auch ungerichtet erstarrt, besteht. Mehrere dieser entstandenen Vorprodukte werden nun entweder komplett oder nach Entfernen der typischerweise am stärksten verunreinigten Deckel- und Randbereiche verwendet, um erneut einem Kristallzuchtprozess unterworfen zu werden. Hierbei kommen mehrere der genannten Vorprodukte oder Teile derer in einer Gesamtmenge von 100-200kg und eine geringe Menge von <3% Scavenger in einem Tiegel von 300-500mm Durchmesser zum Einsatz. Der nun beginnende Zuchtprozess kann entweder nach dem Bridgemann-Stockbarger-Verfahren oder der Vertical-Gradient-Freeze-Technologie durchgeführt werden. Wichtig ist die Verwendung eines Keimes, der das Wachsen eines Einkristalles vom Boden des Tiegels beginnend nach oben gewährleistet. Entscheidend für den Erfolg des erfindungsgemäß durchzuführenden Temperprozesses ist, dass der Einkristall sehr langsam wächst (typischerweise mit einer Wachstumsrate von < 2 mm/h) und nach Abschluss des Zuchtprozesses in verschiedenen Temperaturbereichen unterschiedlich schnell, aber nie schneller als 10K/h bis auf Raumtemperatur abgekühlt wird. Auf diese Art wird ein ausreichend guter Rohkristall erhalten, der vor dem Tempern bereits eine durchschnittliche Spannungsdoppelbrechung von ca. 5-20nm/cm(RMS-Werte) aufweist.

Aus dem so erhaltenen Kristall eine (100)-orientierte Scheibe mit einem Durchmesser von 270 mm herausgeschnitten.

Diese Scheibe wurde anschließend getempert. Zunächst wurde die Restfeuchte bei einer Temperatur von 370°C innerhalb von 24h im Hochvakuum entfernt. Anschließend wurde unter einem N2-Schutzgas bei einem Druck von 15mbar gearbeitet. Als Scavengermaterial wurde ZnF2 verwendet und zusätzlich wurden ca. 500g CaF2-Pulver zugegeben. Die Scheibe wurde bis 1170°C mit einer Temperaturrate von 12K/h aufgeheizt und bei dieser Temperatur 75h gehalten. Die Abkühlung erfolgte mit 0,28K/h bis auf 920°C, mit 0,42K/h bis 700°C/h und mit 0,8K/h bis Raumtemperatur.

Anschließend wurde die Spannungsdoppelbrechung (SDB) sowie die Brechzahl entlang der Oberfläche bestimmt. Dabei wurde die Scheibenoberfläche im Abstand von 2mm über den Prüfdurchmesser abgerastert und aus diesen Werten der Mittelwert(RMS-Wert) bestimmt. Anschließend wurde der äußere Rand abgetragen und zwar auf einen Außendurchmesser von 252 mm, und die SDB wie zuvor nochmals bestimmt. Diese Vorgehensweise wurde mit weiter verringerten Durchmessern 234 mm, 216 mm und 207 mm wiederholt. Wie sich der folgenden Tabelle 2 entnehmen lässt, können dadurch im Inneren des Kristall vorliegende elastische Spannungen abgebaut werden. Bei einer Kristallscheibe von 270 mm Durchmesser verringert sich die SDB in einem inneren Ring von 150 mm von 1,489 nm/cm auf 1,022 nm/cm, nachdem der Durchmesser von 270 auf 207mm abgearbeitet wurde. Dies bedeutet eine Verbesserung auf 69% des alten Wertes. Bei einem inneren Ring von 170 mm nimmt die durchschnittliche Spannungsdoppelbrechung (SDB) von 1,489 nm/cm auf 1,047 ab, was einer Abnahme auf 70% entspricht. Beachtet man dabei, dass diese Werte an einem Kristall entlang einer optischen Achse in 100 Richtung durchgeführt worden sind, lässt sich daraus die Wichtigkeit des neuen Verfahrens ermessen, da derart orientierte Kristalle bislang kaum spannungsfrei herstellbar waren.

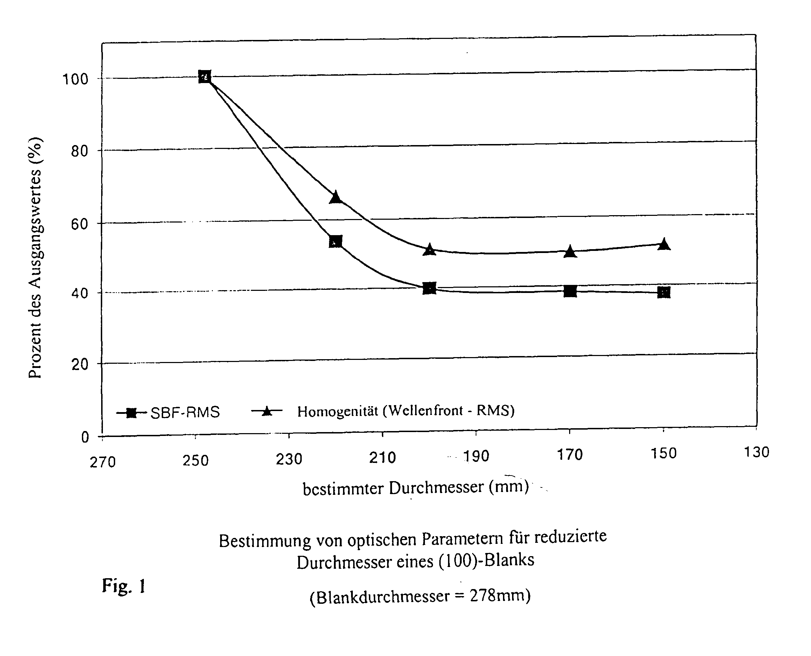

Messungen bzgl. der Homogenität des Brechungsindex zeigen denselben erfindungsgemäßen Effekt, wie sich der beiliegenden Figur 1 entnehmen lässt.

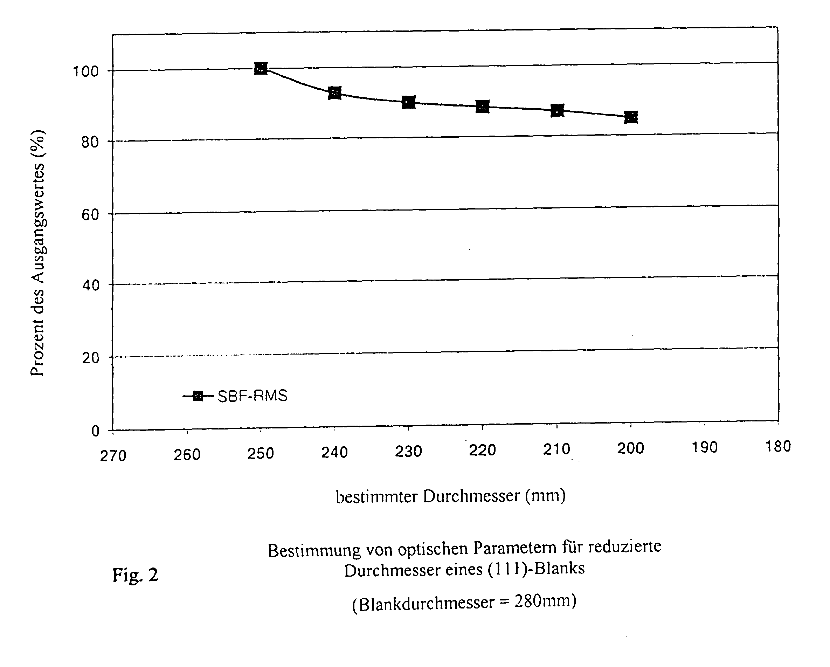

Der erfindungsgemäße Effekt ist auch bei den Kristallscheiben ausgeprägt, die entlang ihrer 111-Richtung durchstrahlt werden. Diese Ergebnisse sind in Figur 2 dargestellt.

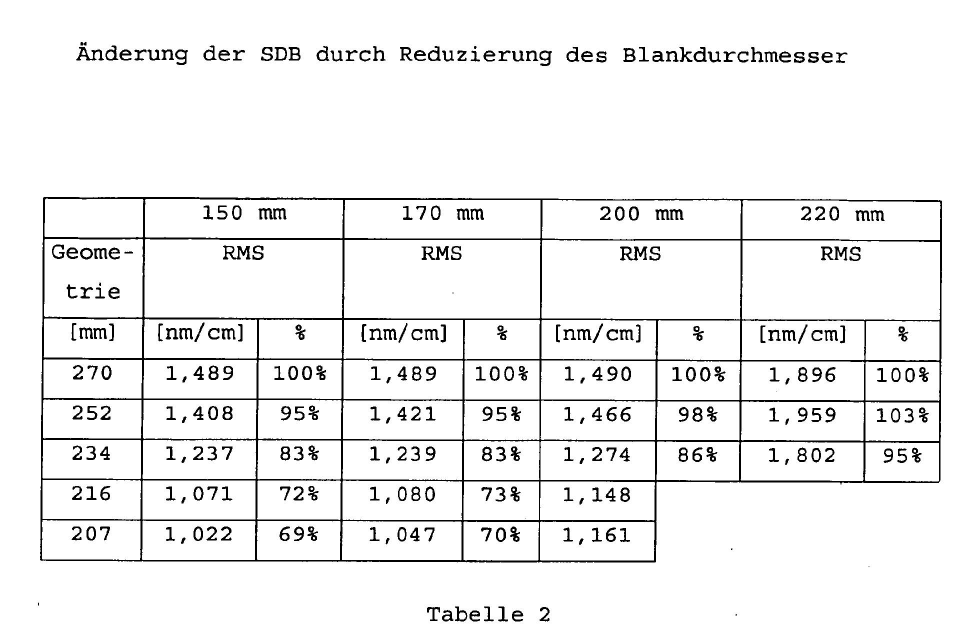

## Patentansprüche

1. Verfahren zur Herstellung eines spannungsarmen, großvolumigen Kristalls in einer durch Durchmesser und Höhe definierten Dimension, die eine geringe Doppelbrechung und homogene Brechzahl aufweisen, umfassend Züchten eines Kristalles aus einer Schmelze, Abkühlen des so erhaltenen Kristalles, sowie Tempern und Bearbeiten auf eine gewünschte Dimension, **dadurch gekennzeichnet, dass** man den Kristall in einer größeren als der gewünschten Dimension tempert, und man nach dem Tempern und Abkühlen den äußeren Randbereich auf die gewünschte Dimension soweit abträgt, dass der Durchmesser und/oder die Höhe um mindestens 5% verringert wird und dass nach dem Entfernen des Randbereiches kein weiteres Tempern erfolgt.

2. Verfahren nach Anspruch 1, **dadurch gekennzeichnet, dass** durch das Abtragen der Durchmesser und/oder die Höhe um mindestens 10 % verringert wird.

3. Verfahren nach einem der vorhergehenden Ansprüche, **dadurch gekennzeichnet, dass** der Kristall ein CaF₂-Kristall ist.

4. Verfahren nach einem der vorhergehenden Ansprüche, **dadurch gekennzeichnet, dass** der Kristall in der (111)-Richtung senkrecht zur Erdoberfläche getempert wird.

5. Verfahren nach einem der vorhergehenden Ansprüche, **dadurch gekennzeichnet, dass** der Kristall mindestens auf einer Temperatur oberhalb 1150°C isotherm gehalten wird.

6. Verfahren nach einem der vorhergehenden Ansprüche, **dadurch gekennzeichnet, dass** mit einer Abkühlrate von < 0,5K/h, vorzugsweise < 0,4K/h und insbesondere < 0,3 K/h in einem oberen Temperaturbereich abgekühlt wird, dessen untere Grenze zwischen 900°C und 600°C liegt.

7. Verfahren nach einem der vorhergehenden Ansprüche, **dadurch gekennzeichnet, dass** mit einer Abkühlrate von < 3 K/h, vorzugsweise < 2 K/h und insbesondere < 1,7 K/h in einem unteren Temperaturbereich abgekühlt wird, dessen obere Grenze zwischen 900°C und 600°C liegt und dessen untere Grenze die Raumtemperatur ist.

8. Verfahren nach einem der vorhergehenden Ansprüche, **dadurch gekennzeichnet, dass** beim Tempern die Wärmezufuhr seitlich erfolgt.

9. Kristall erhältlich nach einem der Ansprüche 1 bis 8, **dadurch gekennzeichnet, dass** er eine homogene Brechzahl von Δn < 1*10⁻⁶ aufweist.

10. Kristall nach Anspruch 9, **dadurch gekennzeichnet, dass** er eine Spannungsdoppelbrechung < 0,3nm/cm aufweist.

11. Verwendung von nach dem Verfahren der Ansprüche 1 bis 8 erhaltenen Kristallen, sowie den Kristallen der Ansprüche 9 und 10, als optisches Element, zur Herstellung von Steppern, Excimer-Lasern, Wafern, Computerchips, sowie integrierten Schaltungen und elektronischen Geräte, die solche Schaltungen und Chips enthalten.
